# EUROPEAN PATENT SPECIFICATION

(11) **EP 0 601 460 B1**
(45) Date of publication and mention of the grant of the patent: **10.03.1999**
(21) Application number: 93119358.5
(22) Date of filing: 01.12.1993
(51) Int. Cl.: F02P 1/08, F02P 3/08, H02J 7/14, H02M 7/155

(54) **Electronic power supply system for a capacitive discharge ignition apparatus for internal combustion engines**
Elektronische Spannungsversorgung für eine kapazitive Zündanlage einer inneren Brennkraftmaschine
Système d'alimentation électronique pour un dispositif d'allumage à décharge capacitive d'une moteur à combustion interne

(30) Priority: 10.12.1992 IT MI922809
(43) Date of publication of application: 15.06.1994
(73) Proprietor: DUCATI ENERGIA S.p.A., 40132 Bologna (IT)
(72) Inventor: Biondi, Astorre, 40017 - S.G.Persiceto (Bologna) (IT); Regazzi, Gianni, 40100 Bologna (IT)
(74) Representative: Coloberti, Luigi

(56) References cited:
- EP-A- 0 301 436
- DE-A- 2 246 905
- DE-A- 2 401 133
- DE-A- 2 415 465
- FR-A- 2 534 635
- US-A- 4 537 174
- US-A- 4 983 886
- US-A- 5 049 786
- PATENT ABSTRACTS OF JAPAN vol. 8, no. 61 (M-284) 23 April 1984 & JP-A-58 211 563 (NIPPON DENSO KK)
- PATENT ABSTRACTS OF JAPAN vol. 13, no. 300 (M-848) 11 July 1989 & JP-A-01 092 578 (NIPPON DENSO CO LTD) 11 April 1989

## Description

The present invention relates to an electronic supply system for capacitive-discharge ignitions for internal combustion engines, by means of which it is possible to raise to a maximum and control the charge voltage of the ignition capacitor both at low and high running speeds of the engine, using a simplified electric generator.

The effective working range of modern electronic ignitions has been considerably extended consequent to the increase in the performances of engines which, on starting up, require ignition even at very low speeds, equal to 200 revolutions per minute, while at very high speeds, can reach and exceed 14,000 r.p.m., in relation to the range of 400 - 8,000 r.p.m. which can be obtained in engines of the older generation. This fact, and the increase in compression ratios, has led to a demand for ignition voltages which are considerably higher than those of the past.

In traditional ignition systems, use was made of a stator winding consisting of thousands of thin-wire turns, for example 0.1 mm in diameter, wound on a coil former which was fixed onto the stator core with a suitable short circuit turn which was mechanically clamped with the winding of the generator. Ignition systems using short circuit turns in the generator are for example mentioned in GB-A. 1.096.212. US-A-4.537.174; EP-A-0 301 436; FR-A-2.534.635; DE-A- 2.415.465; Patent Abstracts of Japan Vol. 8, N.61 (M-284) & JP-A- 58 211.563; DE-A- 2.246.905; US-A-4.983.886 DE-A-2.401.133; US-A-5.049.786 also, are typical examples of ignition systems known from prior art.

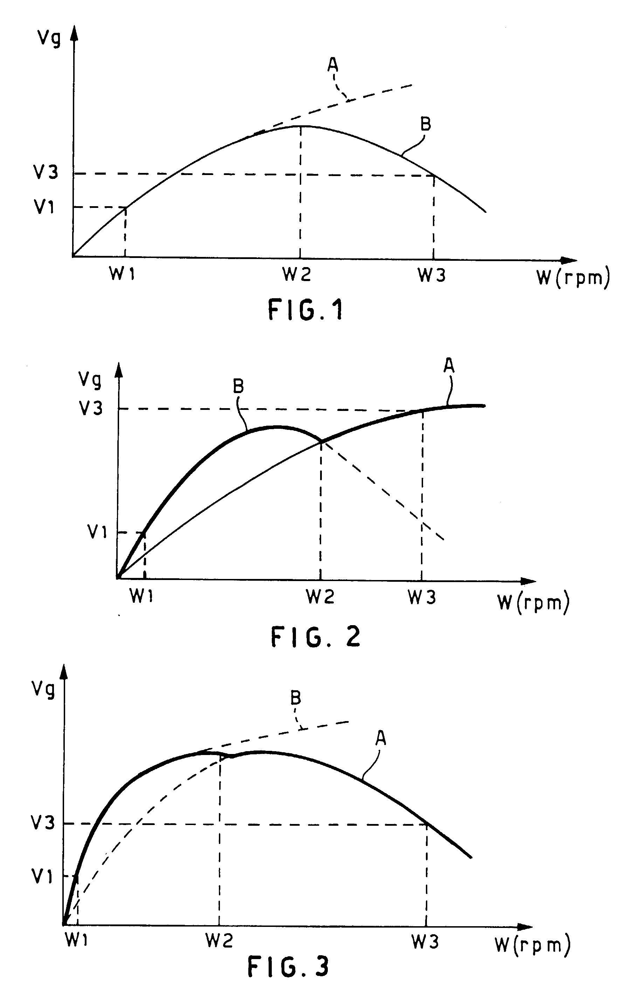

In order to achieve a good ignition cut-in with the ignition system according to GB-A-1.096.212 many turns are therefore required on the winding for charging the capacitor, with the need at times to use several stator poles in order to achieve the required ignition voltage value. Nevertheless, the increase in the number of turns of the winding, which although on one hand enables the problem of the supply voltage at idling or low running speeds of the engine to be solved, on the other hand can create an additional problem since, as soon as the idling condition of the engine has been exceeded, the voltage across the ignition capacitor to rise very rapidly with the increase of the rotational speed of the engine, with a consequently destructive effect on the ignition circuit itself. The dotted curve A in the graph in Fig. 1 shows this effect and the rapid increase in the voltage Vg of the generator beyond an acceptable limit for the ignition system.

In order to avoid the excessive increase in the supply voltage, use was therefore made of large short circuit turns to limit the generator voltage above a number of revs W2 of the engine, between the minimum W1 required for starting the engine and the maximum W3 providing a voltage V3 sufficient for fulfilling the minimum requirements of operation of the same engine, by using the effect of the eddy current losses induced by the magnetic field of the generator. The curve B of the graph in Fig. 1 shows in its right-hand part the effect of the short circuit turns, and the characteristic "bell" shape of the ignition capacitor supply voltage.

This system nevertheless has considerable disadvantages, more particularly due to the bell shape of the supply voltage of the ignition capacitor, which has to be adapted on each occasion to fulfil the varying supply needs both at low and high running speeds of the engine. Moreover, between the two limits of the running speeds of the engine, the voltage V is much higher compared to the minimum requirements of the engine (V3), uselessly stressing the system, with consequent excessive overheating of the supply coil or coils of the ignition circuit of the engine.

With ignitions provided with supply systems of the type mentioned above, the demands of modern engines cannot therefore be met, with the risk of jeopardising the reliability of the system itself. Moreover, the structural heterogeneity of the pole pieces of the stator pack of the generator and the presence of short circuit turns, make mechanical assembly highly complex, with subsequently higher costs for the generator.

In order to avoid in part the abovementioned disadvantages, DE-A-2.401.133 proposes the use of differentiated windings composed of a first winding consisting of a high number of thin-wire turns, with short circuit turns, for supplying the voltage of the ignition circuit at low running speeds of the engine, and a second winding with a smaller number of turns, for supplying the required voltage for high running speeds. The use of differentiated windings is for example disclosed by patent US 3.933.139.

The graph in Fig. 2 shows the result which can be obtained by the combined use of two differentiated windings; more particularly the curve B shows the classic bell trend of the voltage supplied by the first winding with short circuit turns, while curve A indicates the trend of the voltage across the second ignition supply winding. The marked line in this figure shows the trend of the resulting effective voltage curve, where for speeds lower than W2 the voltages supplied by the first winding are used, whereas for higher rotation speeds the voltages of the second winding are used.

Although this system allows the voltages of curve B to be maximised in relation to curve A, at low speeds, lower than W2, and good performances, it is not sufficient for fulfilling the requirements of modern ignitions in that it has disadvantages and difficulties due to the need to use different windings, with costly and complex adjusting operations, as well as the need to use in any case short circuit turns on the first winding, or to configure the respective pole shoes differently, with consequent lack of uniformity of the stator pack and high working temperatures of the windings.

By using two windings in a similar manner to the previous system, an electronic system which exploits the energy accumulated in an inductance, cutting off the electric current at each half wave when it reaches its maximum value, has also been proposed. In this way the ignition supply voltage can be raised at low engine speeds, to sufficiently high values, without nevertheless solving the problem completely and without improving the situation at high running speeds. In fact, in order to avoid that the voltage exceeds certain danger levels, or that the ignition voltage values can be hazardous, it is essential to interrupt the electronic boosting function of the voltage at predetermined numbers of revs of the engine.

The graph in Fig. 3 shows this solution in which the curve B indicates the raising of the supply voltage of the ignition circuit, at low numbers of revs, lower than W2, while the curve A indicates the classic bell curve which has no effect whatsoever on the problems caused at higher running speeds.

Summing up, none of the previously known ignition supply systems for internal combustion engines are able to solve the problems linked to the needs of electronic ignitions for modern internal combustion engines or those which have been produced recently.

From US-A-4.537.174, which constitutes the closest prior art, it is known an apparatus for controlling the supply of an output from a magneto generator of an ignition system comprising the combination of features described in the preamble of present main claim; nevertheless in the apparatus according to this document limitations exist in charging the ignition capacitor due to the presence of a short-circuiting SCR (11) controlled one time only each positive half-cycle output of the generator.

Therefore the object of the present invention is to provide an electronic system for supplying a capacitive-discharge ignition of internal combustion engines, comprising a supply circuit which is able to provide an ignition voltage which is uniform and substantially constant throughout the entire operating range of the engine.

A further object of the present invention is to provide an ignition system, as related above, which is able to supply the required charge voltages for the ignition capacitor, both at low and high numbers of revs, without causing hazardous thermal and electric stresses to the system itself thus maintaining a high degree of reliability and an extremely simple construction of the electric generator.

The abovementioned objects can be achieved by means of an electronic supply system for capacitive-discharge systems of internal combustion engines, having the characterising features of the main claim. Preferred embodiments of the invention are defined in the dependent claims.

JP-A-01/092578 discloses a system for charging an ignition capacitor using transient voltages generated by periodic interruption of the short-circuit current of a generator winding. The time interval between the partial charges of the ignition capacitor is determined by a pre-set timer.

The capacitive-discharge ignition system according to the invention will be illustrated in greater detail hereinunder, with reference to the figures in the accompanying drawings in which:
- Fig. 1: shows the bell trend of the voltage curve in a known ignition circuit comprising a generator which uses at least one winding with short circuit turns;
- Fig. 2: shows the voltage curve of a known ignition circuit comprising a generator in which two differentiated windings are used;
- Fig. 3: shows the voltage curve of a known ignition circuit which uses a known electronic system for raising the charge voltage of the ignition capacitor at low speeds;
- Fig. 4: shows a first embodiment of an ignition system according to the invention;
- Fig. 5: shows various diagrams of the voltages at significant points of the circuit in Fig. 4, to illustrate the operating principle;
- Figs. 6A, 6B and 6C: show diagrams of the significant voltages in a similar manner to the diagram in Fig. 5, for different running speeds of an engine;
- Fig. 7: shows the supply voltage curve of the ignition circuit according to the invention, compared to a traditional bell curve;
- Fig. 8: shows a first variation of the circuit according to the invention;
- Fig. 9: shows a second variation as an alternative to the previous solutions.

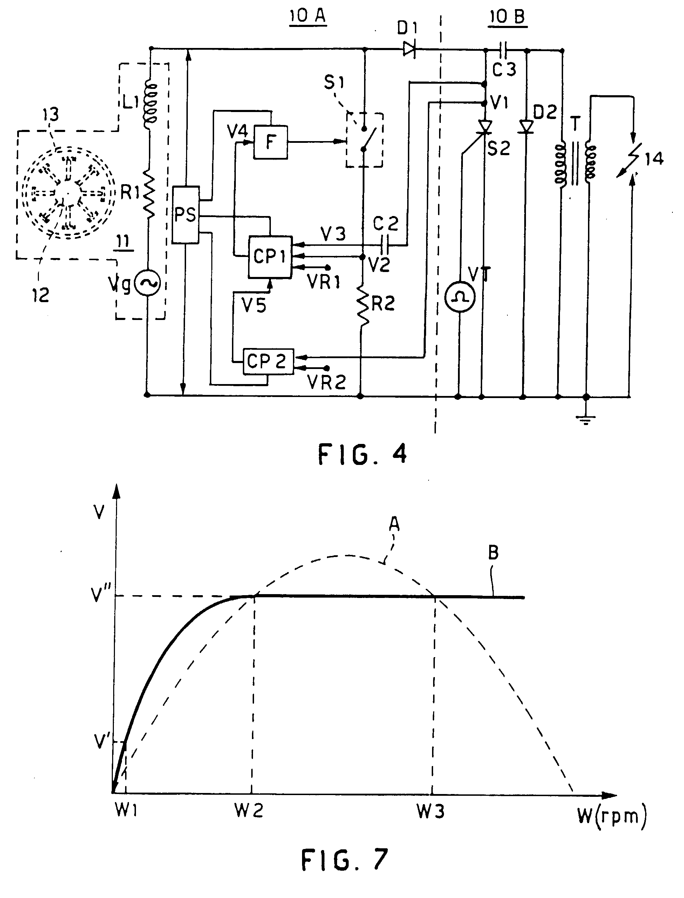

With reference to Fig. 4, we will first describe the basic circuit according to a first embodiment of a capacitive-discharge ignition for internal combustion engines of motor vehicles, or for other applications, which has been innovated with a voltage raising or boosting system for charging the ignition capacitor to a maximum charge voltage, according to the invention.

10A in Fig. 4 denotes the supply part of the circuit for charging the ignition capacitor, while 10B denotes the discharging part of the circuit. More particularly part 10A of the circuit comprises a winding of an AC electric generator 11, having in a known manner, a stator 12 provided with appropriate windings for generating service voltages and voltage for supplying the ignition circuit, while 13 denotes a rotor supporting the magnetic field energising the coils or windings of the stator 12. The shape and features of the electric generator 11 will not be illustrated further since, with the exception of the winding for supplying the ignition, they do not form substantial parts of the present invention.

In the same Fig. 4, Vg, R1 and L1 substantially denote the source of electromotive force, resistance and internal inductance of a winding of the stator 12, dedicated to generate voltage and current for charging a capacitor C3 forming part of the ignition circuit for an internal combustion engine, as represented schematically.

As related, the ignition circuit comprises the supply part 10A for generating voltage for charging the capacitor C3, which has been innovated according to the present invention, as well as the part 10B for controlling the discharge of C3 on sparking plug 14, by means of a high voltage coil T synchronously operating with the generator 11 and of the internal combustion engine to which the whole system is correlated.

In general, in the example shown, the circuit 10B for discharge of the capacitor C3 is connected to the winding L1 of the voltage generator 11 by a diode rectifier D1; the circuit moreover comprises a controlled switch S2 which commands the discharge of the capacitor C3 onto the ignition coil T according to a synchronous timing signal VT supplied by a suitable coil of the generator, or in another appropriate known manner, and also comprises a diode D2 for circulating the current for charging the capacitor C3.

According to the invention, the part 10A for supplying the charge voltage to the capacitor C3, in parallel to the winding L1, R1 of the generator 11, comprises an auxiliary circuit for circulation of the current of the generator, consisting of an electronic switch S1 and a resistor R2 or another equivalent circuit, suitable for supplying a voltage V2 proportional to the current I flowing through the same electronic switch S1 to control ON-OFF actuations in rapid succession of the switch S1.

The ON-OFF actuations of the electronic switch S1 by means of which C3 can be charged at a substantially constant voltage value, independently of the output voltage from the generator 11 and the running speed of the engine, are controlled, via an interface F, by a first voltage comparator CP1 supplied at its inputs with the voltage V2 existing across R2, with a voltage V3 suitable for maintaining an operative state of comparator CP1, provided for example by a capacitor C2, or another device suitable for providing a derivative function of the increase in voltage V1 across C3, during each individual partial charging phase of the capacitor, as explained hereinbelow, as well as a reference voltage VR1 indicating the maximum level of V2 in relation to which CP1 commands the actuation and de-actuation in rapid succession of the static switch S1.

In the same Fig. 4, CP2 denotes an inhibiting device for CP1, suitable for defining the maximum voltage level V1 for C3, consisting for example of a second voltage comparator which continuously compares the voltage V1 of the capacitor C3 with a reference voltage VR2 for preventing operation of CP1 when V1 reaches or tends to exceed the maximum charge voltage level allowed for C3. Therefore the output V5 of CP2 is sent to a control input of CP1 for the purpose related above.

Finally PS schematically denotes a circuit for supplying power to the various functional blocks which form part of the supply system of an electronic ignition for internal combustion engines according to the invention.

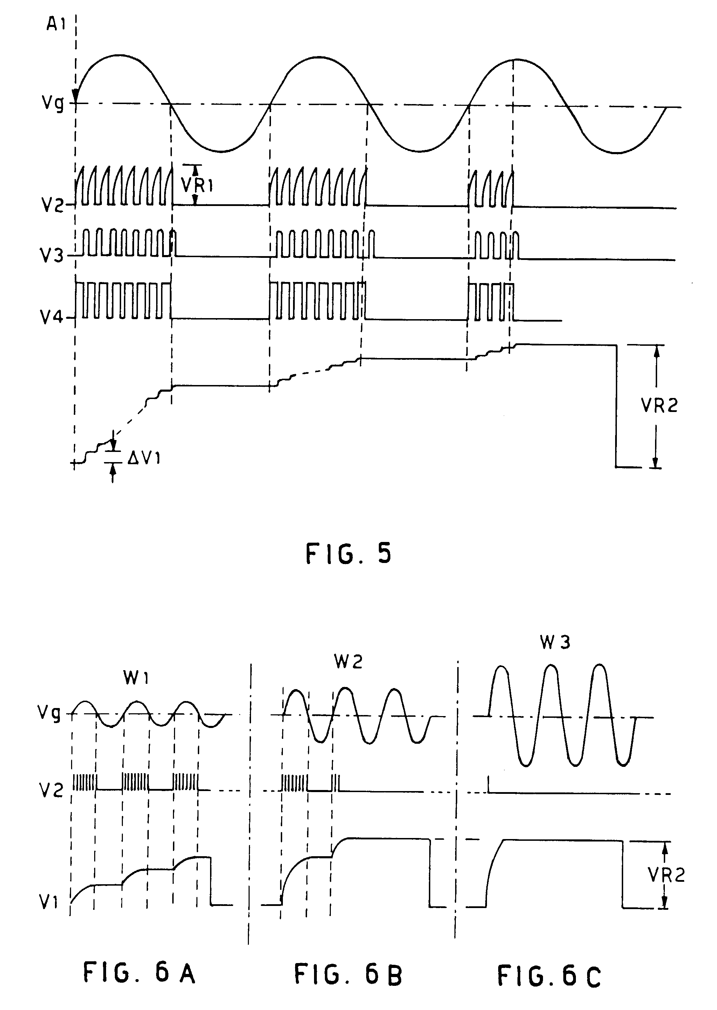

Referring now to Fig. 4 and to Fig. 5, we will describe the mode of operation and the fundamental features of the electronic supply system for capacitive-discharge ignitions according to the present invention.

In this respect it has to be said that the energy obtainable from a single winding of a stator pole of the generator 11 is more than sufficient for ensuring charging of the capacitor C3, and a good spark for the engine. It nevertheless has to be considered that the capacitor C3 of the ignition circuit has to be repeatedly charged at a voltage of a few hundreds of Volts, for example 200 or 300 Volts to store the electric energy required for igniting the engine. Moreover, a winding of a stator pole, formed by a few number of turns, is able to supply, at low speeds, a very low voltage, for example in the order of a few volts, and a relatively high current, for example approximately 1 Ampere, whereas for higher speeds, in the order of 5,000 - 6,000 r.p.m., the power provided by a similar winding, in terms of voltage and current, would be sufficient for supplying the entire capacitor discharge circuit 10B.

The present invention, in order to avoid the problems occurring in previous ignition systems, is based on the principle of using a single stator winding L1 of the generator 11, preferably without short circuit turns, formed by a few hundred turns of wire, for example consisting of 300-400 turns approximately of wire which is for example 0.3 mm in diameter, operating in such a way as to transform the energy (1/2 LI²) accumulated by the synchronous inductance relating to this winding L1 of the generator, into electric energy expressed in terms of voltage and capacitance (1/2 CV²) for charging the ignition capacitor C3.

The above can be obtained in a system according to the invention, short-circuiting or ON-OFF actuating several times in rapid succession the static switch S1 located in parallel to the specific stator winding L1 of the generator 11, under the control of the voltage comparators CP1 and CP2, as explained hereinunder with reference to Fig. 5.

Starting from point A1 of the first graph in Fig. 5 which represents the trend of the sinusoidal voltage Vg of the AC generator 11, for a certain speed or number of revs of the engine, the switch S1 is deactuated in that it has been commanded, via the interface F, by the voltage comparator CP1. The output V4 of the latter is in fact active since the voltages in input V2 and V3 are initially zero, or lower than the reference voltage VR1 indicating the maximum value of the current I which can flow through the switch S1. Moreover CP1 is not inhibited by the voltage comparator CP2 since the voltage V1 across the capacitor C3 is zero or lower than the reference voltage VR2, C3 being still discharged in the instant A1 considered.

As the voltage Vg of the generator increases, during the first positive half wave, the current I, flowing through S1 and R2, will increase and consequently the voltage V2 will rise until it reaches the reference voltage value VR1 (Fig. 5 - second graph).

At this point the output V4 (Fig. 5 - fourth graph) of the voltage comparator CP1 changes state, with the output V4 inactive, commanding the opening of S1 and sudden interruption in the current I flowing in the inductance L1 of the generator. In this way an overvoltage is achieved due to inductive reaction, across the circuit L1, R1 of the generator. Therefore the energy stored in the magnetic field of the inductance L1, proportional to the square of the current circulating therein, flows into C3, causing a suitable current to circulate via D1 and D2. Thus a phase of partial charging of the capacitor C3 is performed, of a value Δ V1 (Fig. 5 - fifth graph), proportional to the capacity of C3, to the energy accumulated in the inductance L1, to the voltage V1 and to the voltage Vg of the generator.

When switching OFF or opening the switch S1, the current I flowing in R2 drops to zero bringing the voltage V2 below the reference value VR1. In order to allow the partial charge Δ V1 of the capacitor C3 to continue for the necessary time, the capacitor C2 performs the derivative function of V1, transforming it into a voltage pulse V3 (Fig. 5 - third graph) which maintains CP1 in a de-activated state and hence S1 in OFF state for the time required for completing this phase of partial charge of the ignition capacitor C3.

As soon as the partial charge Δ V1 of the capacitor C3 has ended, the derivative voltage V3 supplied by the capacitor C2 drops to zero and the comparator CP1 changes state, in other words, it becomes active again, switching ON or OFF switch S1 again.

This phenomenon is sequentially repeated several times in rapid succession for all the half waves involved or part of them, with a predetermined frequency, which depends on the setting parameters of the circuit and on the rotational speed.

The phenomenon is to be repeated throughout the half waves involved, gradually charging, step by step, the capacitor C3 and will only be interrupted when the voltage V1 across C3 reaches a required value defined by the reference voltage VR2 of the second comparator CP2. At that time the output V5 of the comparator CP2 will inhibit operation of CP1, and the switch S1 will remain OFF independently of the input voltages V2 and V3 of CP1.

Once C3 has been charged, it may in turn be discharged onto the ignition circuit, synchronously with the operation of the engine, via a trigger signal VT supplied to the control electrode of the switch S2, in accordance with the operation mode of traditional capacitive ignition circuits.

The diagrams in Figs. 6A, 6B and 6C show that the operation mode of the circuit does not change and remains substantially the same both at minimum running speeds (W1) at average speeds (W2), and at maximum or high speeds (W3), corresponding to different maximum values of the sinusoidal voltages Vg generated by the alternator 11 at the same charge voltage of C3. In the figures it can be seen that for very low speeds (Fig. 6A), the circuit is practically always in operation, until the charge voltage required for the capacitor C3 is reached, whereas for average speeds (Fig. 6B), partial operation occurs. Finally for high speeds (Fig. 6C), the circuit can come into operation only once without having any effect since the voltage of the generator itself is more than sufficient for charging C3.

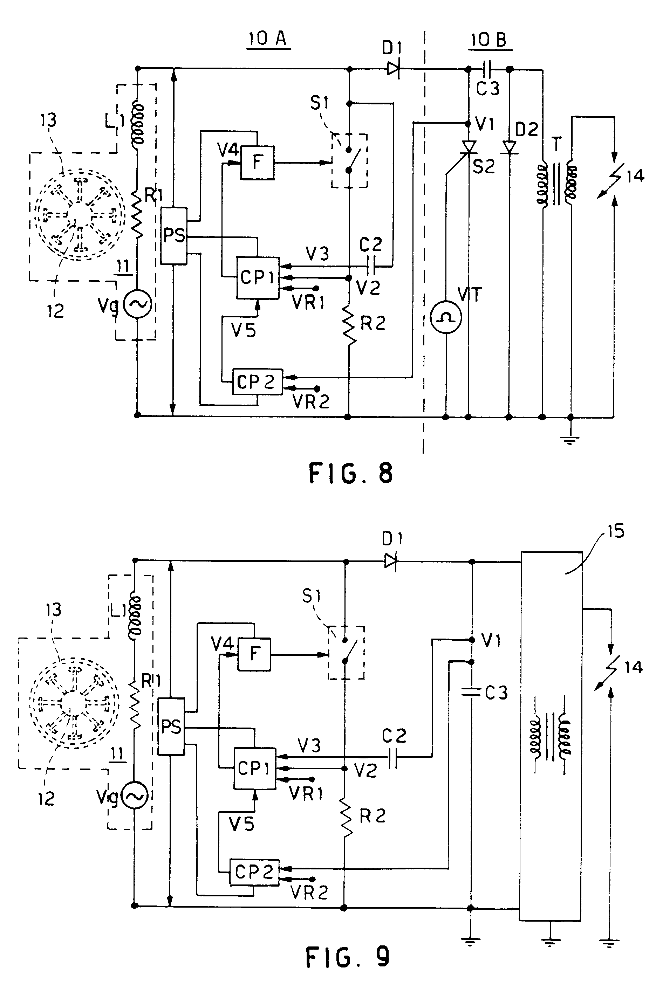

The final performances of the system can be seen in Fig. 7 where A again denotes the classic bell curve of the voltage supplied by the winding alone of the generator, where bucking coils are used, while B indicates the curve of the voltage actually available for charging C3.

Fig. 7 shows two essential facts, namely: the raising to a maximum value of the charge voltage both at low speeds, or for values lower than W2, and at high running speeds, or for values higher than W3, as well as a substantial levelling of the voltage curve at average speeds for a substantially constant voltage value, self-limited by the system via the action of the voltage comparator CP2.

In this way it has been possible to boost to admissible values the supply or charge voltage of the ignition capacitor C3, using a winding of the generator 11, which is extremely rugged in construction and not subject to hazardous overheating, at the same time simplifying the construction and setting-up of the same generator and of the entire ignition system.

Figures 8 and 9 of the accompanying drawings show two variants which are characterised by a different connection in Fig. 8 of the capacitor C2, and of the same ignition capacitor C3 in Figure 9. It can be seen in Figure 8 in fact that C2 is connected to the anode of the rectifier diode D1, while in Fig. 9 C3, which in the previous examples was connected in series with T, is now connected between the cathode of D1 and the circuit ground. It is in any case clear that other variants are possible, in relation to what has been shown, without thereby departing from the innovative principles of the invention claimed.

## Claims

1. An energy supply system for a capacitive-discharge ignition circuit of an internal combustion engine, in which the ignition circuit (10B) comprises a capacitor (C3) for storing electric energy provided by an AC voltage generator (11), and a discharge circuit comprising an ignition coil (T) having a primary winding connected to said capacitor (C3), and a secondary winding connected to a spark-plug (14) of the combustion engine, and a discharge control switch (S2) in the ignition circuit to discharge the capacitor (C3) onto the ignition coil (T) and feed the electrical energy stored in said capacitor (C3) to said spark-plug (14) under the control of a timing signal (VT) synchronously generated with the running of the engine; the said energy supply system comprising the said AC voltage generator (11) and means (S1) for inductively raising the voltage (V1) provided by the voltage generator (11) to charge the ignition capacitor (C3) to a maximum charge voltage (Vr2), said means for raising the voltage (Vg) of the voltage generator (11) consisting of an auxiliary circuit (10A) for circulation of generator current, said auxiliary circuit (10A) comprising a stator winding (*L1*) of the voltage generator (11) and an electronic control switch (S1) to enable the circulation of a short-circuit current (I) generated by the voltage generator (11), when in the ON state, and the charging of the ignition capacitor (C3) with the current generated by a high induced voltage produced upon interruption of the short-circuit current (I) flowing in said stator winding (L1), when said electronic control switch (S1) is switched in the OFF state, characterised in that switch control means (CP1, F, R2) are provided in said auxiliary circuit (10A) for emitting pulse control signals (V4) for sequentially ON-OFF switching said electronic switch (S1) according to a first control signal (V2) related to the value of the current (I) generated by said stator winding (L1) of the generator (11) to switch said electronic switch (S1) enabling a partial charging phase of the ignition capacitor (C3), when said first control signal (V2) reaches a predetermined level, and to a second control signal (V3) related to a derivative of the voltage (V1) of the ignition capacitor (C3) to maintain the said electronic switch (S1) switched OFF in the charging state during each partial charging phase of the ignition capacitor (C3), as well as comprising inhibiting means (CP2) for inhibiting said switch control means (CP1) to switch OFF the electronic switch (S1) when the voltage (V1) of the ignition capacitor (C3) sensed by the inhibiting means has reached said maximum charge voltage (VR2).

2. An energy supply system according to claim 1, characterised in that said swith control means (CP1, F, R2) for the electronic switch (S1), comprises voltage generating means (R2) for generating a control voltage (V2) proportional to the current (I) flowing from the generator (11), and a first voltage comparator (CP1), said voltage comparator (CP1) receiving as inputs said control voltage (V2) and a reference voltage (VR1), and further comprising second control voltage generating means (C2) for maintaining said first comparator (CP1) in an operative state in which said electronic switch (S1) remains switched in an OFF condition during each individual partial charging phase of the ignition capacitor (C3).

3. An energy supply system according to claim 2, characterised in that said second voltage generating means (C2) for maintaining the first comparator (CP1) in said OFF operative state, comprise a derivative voltage generating device (C2) for supplying said first voltage comparator (CP1) with a voltage control signal (V3) which is a derivative function of the instantaneous charge voltage (V1) of the ignition capacitor (C3).

4. An energy supply system according to claim 3, characterised in that said derivative voltage generating device comprise a second capacitor (C2) connected between the ignition capacitor (C3) and a control input (V3) of the first voltage comparator (CP1).

5. An energy supply system according to claims 1 and 2, characterised in that said means for inhibiting the switch control means (CP1, F, R2) comprise a second voltage comparator (CP2) connected to a control inlet (V5) of the first voltage comparator (CP1), said second voltage comparator (CP2) being fed at an input with a control voltage proportional to the charge voltage (V1) the ignition capacitor (C3) and at a second input with a reference voltage (VR2) corresponding to the maximum charge voltage allowed for the ignition capacitor (C3).

## Patentansprüche

1. Energieversorgungssystem für eine Zündschaltung mit kapazitiver Entladung eines Verbrennungsmotors, wobei die Zündschaltung (10B) einen Kondensator (C3) zum Speichern elektrischer Energie, die von einem Wechselspannungsgenerator (11) bereitgestellt wird, sowie eine Entladungsschaltung enthält, die ihrerseits eine Zündspule (T) mit einer an den Kondensator (C3) angeschlossenen Primärwicklung und einer an einer Zündkerze (14) des Verbrennungsmotors angeschlossenen Sekundärwicklung und einen Entladungssteuerungsschalter (S2) in der Zündschaltung zum Entladen des Kondensators (C3) zur Zündspule (T) und zum Liefern der im Kondensator gespeicherten elektrischen Energie an die Zündkerze (14) unter der Steuerung eines synchron mit dem Motorlauf erzeugten Taktsignals (VT) enthält; wobei das Energieversorgungssystem den Wechselspannungsgenerator (11) und eine Einrichtung (S1) zum induktiven Anheben der vom Spannungsgenerator (11) bereitgestellten Spannung (V1) enthält, um den Zündkondensator (C3) auf eine maximale Ladespannung (Vr2) zu laden, wobei die Einrichtung zum Anheben der Spannung (Vg) des Spannungsgenerators (11) aus einer Hilfsschaltung (10A) für die Zirkulation eines Generatorstroms besteht, wobei die Hilfsschaltung (10A) eine Statorwicklung (L1) des Spannungsgenerators (11) und einen elektronischen Steuerungsschalter (S1) enthält, der die Zirkulation eines vom Spannungsgenerator (11) erzeugten Kurzschlußstroms (I) freigibt, wenn er in den EIN-Zustand geschaltet ist, und der das Laden des Zündkondensators (C3) mit dem Strom, der von einer bei der Unterbrechung des in die Statorwicklung (L1) fließenden Kurzschlußstroms (I) erzeugten hohen induzierten Spannung erzeugt wird, freigibt, wenn er in den AUS-Zustand geschaltet ist, dadurch gekennzeichnet, daß in der Hilfsschaltung (10A) Schaltsteuerungseinrichtungen (CP1, F, R2) vorgesehen sind, um Impulssteuersignale (V4) zum sequentiellen EIN- und AUS-Schalten des elektronischen Schalters (S1) entsprechend einem ersten Steuersignal (V2), das mit dem Wert des von der Statorwicklung (L1) des Generators (11) erzeugten Stroms (I) in Beziehung steht und den elektronischen Schalter (S1) in der Weise schaltet, daß eine Teilladungsphase des Zündkondensators (C3) freigegeben wird, wenn dieses erste Steuersignal (V2) einen vorgegebenen Pegel erreicht, und entsprechend einem zweiten Steuersignal (V3), das mit einem Differential der Spannung (V1) des Zündkondensators (C3) in Beziehung steht und den elektronischen Schalter (S1) im Ladezustand während jeder Teilladephase des Zündkondensators (C3) AUS-geschaltet hält, auszusenden, und daß Sperreinrichtungen (CP2) so vorgesehen sind, daß sie die Schaltsteuerungseinrichtungen (CP1) daran hindern, den elektronischen Schalter (S1) AUS zu schalten, wenn die Spannung (V1) des Zündkondensators (C3), die von der Sperreinrichtung erfaßt wird, die maximale Ladespannung (VR2) erreicht hat.

2. Energieversorgungssystem nach Anspruch 1, dadurch gekennzeichnet, daß die Schaltsteuerungseinrichtungen (CP1, F, R2) für den elektrischen Schalter (S1) eine Spannungserzeugungseinrichtung (R2) zur Erzeugung einer Steuerspannung (V2), die zu dem vom Generator (11) fließenden Strom (I) proportional ist, und einen ersten Spannungskomparator (CP1) umfassen, wobei der Spannngskomparator (CP1) als Eingänge die Steuerspannung (V2) und eine Referenzspannung (VR1) empfängt, wobei die Schaltsteuerungseinrichtung ferner eine zweite Steuerspannungserzeugungseinrichtung (C2) enthält, die den ersten Komparator (CP1) in einem Betriebszustand hält, in dem der elektronische Schalter (S1) während jeder einzelnen Teilladephase des Zündkondensators (C3) in einem AUS-geschalteten Zustand bleibt.

3. Energieversorgungssystem nach Anspruch 2, dadurch gekennzeichnet, daß die zweite Spannungserzeugungseinrichtung (C2) zum Halten des ersten Komparators (CP1) im AUS-geschalteten Betriebszustand eine Differentialspannungserzeugungseinrichtung (C2) zum Speisen des ersten Spannungskomparators (CP1) mit einem Spannungssteuersignal (V3), das eine Ableitungsfunktion der momentanen Ladespannung (V1) des Zündkondensators (C3) ist, enthält.

4. Energieversorgungssystem nach Anspruch 3, dadurch gekennzeichnet, daß die Differentialspannungserzeugungsvorrichtung einen zweiten Kondensator (C2) enthält, der zwischen den Zündkondensator (C3) und einen Steuereingang (V3) des ersten Spannungskomparators (CP1) geschaltet ist.

5. Energieversorgungssystem nach den Ansprüchen 1 und 2, dadurch gekennzeichnet, daß die Einrichtung zum Sperren der Schaltsteuerungseinrichtungen (CP1, F, R2) einen zweiten Spannungskomparator (CP2) enthält, der an einen Steuereinlaß (V5) des ersten Spannungskomparators (CP1) angeschlossen ist, wobei der zweite Spannungskomparator (CP2) an einem Eingang mit einer Steuerspannung gespeist wird, die zur Ladespannung (V1) des Zündkondensators (C3) proportional ist, und an einem zweiten Eingang mit einer Referenzspannung (VR2) versorgt wird, die der für den Zündkondensator (C3) maximal zulässigen Ladespannung entspricht.

## Revendications

1. Système d'alimentation en énergie électrique pour un circuit d'allumage à décharge capacitive d'un moteur à combustion interne, dans lequel le circuit d'allumage (10B) comprend un condensateur (C3) destiné à emmagasiner une énergie électrique fournie par un générateur de tension alternative (11), et un circuit de décharge comprenant une bobine d'allumage (T) comportant un enroulement primaire connecté audit condensateur (C3), et un enroulement secondaire connecté à une bougie d'allumage (14) du moteur à combustion , et un interrupteur (S2) de commande de décharge se trouvant dans le circuit d'allumage pour décharger le condensateur (C3) dans la bobine d'allumage (T) et envoyer l'énergie électrique, stockée dans ledit condensateur (C3), à ladite bougie d'allumage (14) sous la commande d'un signal de chronodéclenchement (VT) généré en synchronisme avec le fonctionnement du moteur; ledit système d'alimentation en énergie comprenant ledit générateur (11) de tension alternative et un moyen (S1) destiné à élever par induction la tension (V1) fournie par le générateur de tension (11) afin de charger le condensateur d'allumage (C3) jusqu'à une tension de charge maximale (Vr2), ledit moyen destiné à élever la tension (Vg) du générateur de tension (11) consistant en un circuit auxiliaire (10A) destiné à la circulation du courant de générateur, ledit circuit auxiliaire (10A) comprenant un enroulement statorique (L1) du générateur de tension (11) et un interrupteur de commande électronique (S1) destiné à permettre la circulation d'un courant de court-circuit (I) généré par le générateur de tension (11), quand il est placé dans l'état FERMÉ, et la charge du condensateur d'allumage (C3) avec le courant généré par une tension induite élevée produite lors de l'interruption du courant de court-circuit (I) circulant dans ledit enroulement statorique (L1), quand ledit interrupteur de commande électronique (S1) est placé dans l'état OUVERT, caractérisé en ce que des moyens (CP1, F, 42) de commande d'interrupteur sont présents dans ledit circuit auxiliaire (10A) pour émettre des signaux de commande pulsés (V4) destinés à OUVRIR-FERMER séquentiellement ledit interrupteur électronique (S1) en fonction d'un premier signal de commande (V2) en rapport avec la valeur du courant (I) généré par ledit enroulement statorique (L1) du générateur (11) afin d'actionner ledit interrupteur électronique (S1) en permettant une phase de charge partielle du condensateur d'allumage (C3), quand ledit premier signal de commande (V2) atteint un niveau prédéterminé, et d'un deuxième signal de commande (V3) en rapport avec la dérivée de la tension (V1) du condensateur d'allumage (C3) pour maintenir ledit interrupteur électronique (S1) OUVERT dans l'état de charge pendant chaque phase de charge partielle du condensateur d'allumage (C3), ainsi que comprenant un moyen de neutralisation (CP2) destiné à neutraliser ledit moyen de commande d'interrupteur (CP1) afin d'ouvrir l'interrupteur électronique (S1) quand la tension (V1) du condensateur d'allumage (C3) détectée par le moyen de neutralisation a atteint ladite tension de charge maximale (VR2).

2. Système d'alimentation en énergie selon la revendication 1, caractérisé en ce que lesdits moyens (CP1, F, R2) de commande d'interrupteur relatifs à l'interrupteur électronique (S1) comprend un moyen (R2) de génération de tension destiné à générer une tension de commande (V2) proportionnelle au courant (I) circulant à partir du générateur (11), et un premier comparateur de tension (CP1), ledit comparateur de tension (CP1) recevant en tant qu'entrées ladite tension de commande (V2) et une tension de référence (VR1), et comprenant en outre un deuxième moyen (C2) de génération de tension de commande pour maintenir ledit premier comparateur (CP1) dans un état de fonctionnement dans lequel ledit interrupteur électronique (S1) reste placé dans un état OUVERT pendant chaque phase de charge partielle individuelle du condensateur d'allumage (C3).

3. Système d'alimentation en énergie selon la revendication 2, caractérisé en ce que ledit deuxième moyen (C2) de génération de tension destiné à maintenir le premier comparateur (CP1) dans ledit état de fonctionnement OUVERT, comprend un dispositif (C2) de génération de tension de dérivée destiné à alimenter ledit premier comparateur de tension (CP1) avec un signal (V3) de commande de tension qui est une fonction dérivée de la tension de charge instantanée (V1) du condensateur d'allumage (C3).

4. Système d'alimentation en énergie selon la revendication 3, caractérisé en ce que ledit dispositif de génération de tension dérivée comprend un deuxième condensateur (C2) connecté entre le condensateur d'allumage (C3) et une entrée de commande (V3) du premier comparateur de tension (CP1).

5. Système d'alimentation en énergie selon les revendications 1 et 2, caractérisé en e que ledit moyen destiné à neutraliser les moyens (CP1, F, R2) de commande d'interrupteur comprennent un deuxième comparateur de tension (CP2) connecté à une entrée de commande (V5) du premier comparateur de tension (CP1), ledit deuxième comparateur de tension (CP2) étant alimenté, à une entrée, avec une tension proportionnelle à la tension de charge (V1) du condensateur d'allumage (C3) et, à une deuxième entrée, avec une tension de référence (VR2) correspondant à la tension de charge maximale permise pour le condensateur d'allumage (C3).
